Europäisches Patentamt

European Patent Office

Office européen des brevets

(11) Veröffentlichungsnummer: **0 312 965 B1**

(12) **EUROPÄISCHE PATENTSCHRIFT**

(45) Veröffentlichungstag der Patentschrift: **30.12.92**

(21) Anmeldenummer: **88117257.1**

(22) Anmeldetag: **17.10.88**

(51) Int. Cl.5: **H01L 21/00**, H01L 21/205, H01L 21/28, H01L 21/285, H01L 21/31, H01L 21/76, H01L 21/82, H01L 29/72

(54) **Verfahren zur Herstellung eines planaren selbstjustierten Heterobipolartransistors.**

(30) Priorität: **23.10.87 DE 3735999**

(43) Veröffentlichungstag der Anmeldung:
**26.04.89 Patentblatt 89/17**

(45) Bekanntmachung des Hinweises auf die
Patenterteilung:
**30.12.92 Patentblatt 92/53**

(84) Benannte Vertragsstaaten:
**DE FR GB NL**

(56) Entgegenhaltungen:
**EP-A- 0 177 246**

**IEEE ELECTRON DEVICE LETTERS, Band
EDL-8, Nr. 7, Juli 1987, Seiten 303-305, IEEE,
New York, NY, US; M.-C.F. CHANG et al.:
"AlGaAs/GaAs heterojunction bipolar transistors fabricated using a self-aligned dual-
lift-off process"**

**IEEE ELECTRON DEVICE LETTERS, Band
EDL-7, Nr. 1, Januar 1986, Seiten 8-10, IEEE,
New York, US; M.F. CHANG et al.:**

**"GaAs/(GaAl)As heterojunction bipolar transistors using a self-aligned substitutional
emitter process"**

**IEEE ELECTRON DEVICE LETTERS, Band
EDL-7, Nr. 11, November 1986, Seiten
615-617, IEEE, New York, US; J.W. TULLY et
al.: "A fully planar heterojunction bipolar
transistor"**

(73) Patentinhaber: **SIEMENS AKTIENGESELL-
SCHAFT
Wittelsbacherplatz 2
W-8000 München 2(DE)**

(72) Erfinder: **Zwicknagl, Hans-Peter, Dr.
Bruckenäcker 5
W-7000 Stuttgart 80(DE)**
Erfinder: **Willer, Josef, Dr.
Hirschplanallee 3
W-8042 Oberschleissheim(DE)**
Erfinder: **Tews, Helmut, Dr.
Carl-Orff-Weg 1
W-8025 Unterhaching(DE)**

EP 0 312 965 B1

## Beschreibung

Bei der Herstellung von Heterobipolartransistoren wird üblicherweise zunächst der Emitter-Basis-Komplex hergestellt. Zu diesem Zweck wird auf dem Substrat eine Schichtfolge aus verschiedenen und unterschiedlich dotierten Halbleitermaterialien aufgebracht. In der Regel ist die oberste dieser Schichten für den Leitungstyp des Emitters dotiert und wird mit einem entsprechenden Kontakt versehen. Die für die Ausbildung der Basis dotierte Halbleiterschicht liegt etwas tiefer und muß zur Kontaktierung freigelegt werden. Das kann z.B. durch lokales Anätzen und Umdotieren der darüber befindlichen entgegengesetzt dotierten Schichten geschehen. Um die elektrischen Eigenschaften eines solchen Emitter-Basis-Komplexes zu optimieren, muß der Abstand zwischen Basis und Emitter möglichst klein gehalten werden, ohne daß die beiden Bereiche kurzgeschlossen werden. Weil die geometrischen Abmessungen sehr klein sind, sind in der letzten Zeit verschiedene selbstjustierende Herstellungsverfahren für Heterobipolartransistoren vorgeschlagen worden.

In der Druckschrift M. F. Chang e. a.: "GaAs/(GaAl)As Heterojunction Bipolar Transistors Using a Self-Aligned Substitutional Emitter Process¨ in IEEE Electron Device Letters EDL-7, 8 bis 10 (1986) dient eine Fotomaskenschicht zur Definition des Emitterbereiches und als Maske für das Anätzen und anschließende Dotieren der Basisbereiche. Der Implantationsschritt ist erforderlich, weil die oberen Schichten nicht vollständig bis auf die für die Basisleitung dotierte Schicht abgeätzt werden. Diese zusätzlich eingebrachte Dotierung wird anschließend ausgeheilt und ein Dielektrikum zur Ausbildung von Spacern aufgebracht. Diese Spacer dienen dazu, eine getrennte Metallisierung von Emitter und Basis aufbringen zu können.

In der Druckschrift von Ishii e.a.: "High-Temperature Stable $W_5Si_3/In_{0,53}Ga_{0,47}As$ Ohmic Contacts to GaAs for Self-Aligned HBTs" in IEDM 86, S. 274 bis 277 wird ein selbstjustierender Prozeß zur Herstellung eines Heterobipolartransistors beschrieben, bei dem die Emitter-Metallisierung aus $WSi_x$ als Maske für das Abätzen der oberen, für den Leitungstyp des Emitters dotierten Halbleiterschichten sowie die noch erforderliche Implantation zur Dotierung der obersten Schichten des Basisbereiches dient. Anschließend wird mit einem Kurzzeitverfahren diese zusätzliche Dotierung ausgeheilt und die Emitter-Metallisierung einlegiert. Abschließend wird die Basis-Metallisierung aufgebracht.

In der Druckschrift von S. Tiwari: "GaAlAs/GaAs Heterostructure Bipolar Transistors: Experiment and Theory" in IEDM 86, S. 262 bis 265, ist ein Verfahren zur Herstellung von Heterobipolartransistoren auf GaAs-Basis beschrieben, bei dem der Basis-Emitter-Komplex selbstjustierend ausgebildet wird. Außerdem liefert dieser Herstellungsprozeß einen planaren Aufbau. Bei diesem Verfahren wird der Basis-Emitter-Bereich zunächst als Mesa ausgebildet. Die vertikalen Seitenwände werden mittels RIE aus der GaAs-Kontaktschicht hergestellt, worauf eine Siliziumnitrid-Schicht auf der freien Oberfläche abgeschieden wird. Der hochtemperaturstabile ohmsche Emitterkontakt basiert auf einer $n^+$-dotierten InAs-Schicht. Ein Wolframsilizidfilm wird auf dieser Schicht abgeschieden, um den ohmschen Kontakt zu bilden. Mit diesem aufgebrachten Emitterkontakt werden anschließend die $p^+$-Implantate des Basis-Bereiches durch Kurzzeit-Ausheilen bei Temperaturen zwischen 800° und 900° C weniger als fünf Sekunden lang ausgeheilt. Nach Angabe des Autors ergibt sich danach ein Kontaktwiderstand unter 2 x $10^{-6}$ Ω x $cm^2$.

In der Veröffentlichung M.-C.F. Chang u. a.: "AlGaAs/GaAs Heterojunction Bipolar Transistors Fabricated Using a Self-Aligned Dual-Lift-Off Process" in IEEE Electr. Device Lett. EDL-8, 303 - 305 (1987) ist ein Herstellungsverfahren für Heterobipolartransistoren angegeben, bei dem eine für Heterobipolartransistoren übliche Halbleiterschichtfolge auf ein Substrat aufgewachsen wird. Anschließend werden die obersten Schichten im Bereich der Basis bis zur Basisschicht ausgeätzt. Es erfolgt eine Implantierung von Protonen durch diese Öffnung bis in die Kollektorschicht, um die Basis-Kollektor-Kapazität zu reduzieren. Anschließend wird unter Ausnützung der überhängenden Kanten des umgebenden Halbleitermateriales die Basismetallisierung abgeschieden. Eine Isolation der Basismetallisierung von dem umgebenden Halbleitermaterial wird anschließend durch Aufbringen einer $SiO_2$-Schicht vorgenommen. Nachdem eine oberste Schicht zusammen mit den überflüssigen Anteilen der Metallisierung entfernt wurde, wird im mittleren Bereich die Emittermetallisierung auf die Emitterschichten aufgebracht, die durch verbleibende Anteile der $SiO_2$-Schicht von der Basismetallisierung isoliert sind.

Aufgabe der vorliegenden Erfindung ist es, ein Herstellungsverfahren für planare Heterobipolartransistoren anzugeben, bei dem Emitter und Basis selbstjustiert zueinander hergestellt werden.

Diese Aufgabe wird bei dem erfindungsgemäßen Verfahren durch die Verfahrensschritte des Anspruches 1 gelöst.

Es folgt die Beschreibung des Herstellungsverfahrens anhand der Figuren 1 bis 11.

Figur 1 zeigt den Emitter-Basis-Komplex im Querschnitt nach dem dritten Verfahrensschritt.

Figur 2 zeigt den Emitter-Basis-Komplex im Querschnitt nach dem sechsten Verfahrensschritt.

Figur 3 zeigt den Emitter-Basis-Komplex im Querschnitt nach dem siebten Verfahrensschritt.

Figur 4 zeigt den Emitter-Basis-Komplex im Querschnitt nach dem neunten Verfahrensschritt.

Figur 5 zeigt den Emitter-Basis-Komplex im Querschnitt nach dem zehnten Verfahrensschritt.

Figur 6 zeigt den Emitter-Basis-Komplex im Querschnitt nach dem dreizehnten Verfahrensschritt in der Alternative nach Anspruch 1.

Figur 7 zeigt den Emitter-Basis-Komplex im Querschnitt nach dem vierzehnten Verfahrensschritt in der Alternative nach Anspruch 1.

Figur 8 zeigt den Emitter-Basis-Komplex im Querschnitt nach dem siebzehnten Verfahrensschritt in der Alternative nach Anspruch 1 bzw. nach dem achtzehnten Verfahrensschritt in der Alternative nach Anspruch 2.

Figur 9 zeigt den Emitter-Basis-Komplex in der Aufsicht nach dem Ausätzen der Kontaktlöcher für Basis und Emitter.

Figur 10 zeigt den Emitter-Basis-Komplex im Querschnitt nach dem dreizehnten Verfahrensschritt in der Alternative nach Anspruch 2.

Figur 11 zeigt den Emitter-Basis-Komplex im Querschnitt nach dem vierzehnten Verfahrensschritt in der Alternative nach Anspruch 2.

Das erfindungsgemäße Herstellungsverfahren wird im folgenden für einen Transistor auf GaAs-Basis beschrieben. Die Verfahrensschritte lassen sich unmittelbar auf die Herstellung von Heterobipolartransistoren anderer Materialzusammensetzungen, anderer Schichtstruktur und abweichender Geometrie übertragen. Ein Fachmann auf dem Gebiet der Transistorherstellung kann derartige Verfahrensmodifikationen ohne Schwierigkeit vornehmen. Das nachfolgende Ausführungsbeispiel ist daher nur der einfacheren Beschreibung wegen konkret gehalten und bedeutet keine Einschränkung in dem Anwendungsbereich des erfindungsgemäßen Verfahrens.

Auf einem Substrat 1 aus III-V-Halbleitermaterial, z.B. semiisolierendes Galliumarsenid, wird eine für die Herstellung von Heterobipolartransistoren übliche Schichtfolge aus Halbleitermaterial aufgebracht. Auf einem Substrat 1 aus GaAs werden eine erste Halbleiterschicht 2 aus n-leitend dotiertem GaAs, eine zweite Halbleiterschicht 3 aus p-leitend dotiertem GaAs, eine dritte Halbleiterschicht 4 aus n-leitend dotiertem AlGaAs, eine vierte Halbleiterschicht 5 aus n-leitend dotiertem GaAs und eine fünfte Halbleiterschicht 6 aus hoch n-leitend dotiertem GaAs nacheinander aufgewachsen. Diese Schichtfolge wird mit einer ca. 150 nm dicken Passivierungsschicht 7 aus einem Dielektrikum, zum Beispiel $Si_3N_4$, abgedeckt. In einem zweiten Schritt wird eine erste Maskenschicht 20, z.B. eine Fotolackmaske, mit einer Öffnung zur Definition der Basis aufgebracht. In einem dritten Schritt erfolgt durch die Öffnung der ersten Maskenschicht 20 und die Passivierungsschicht 7 hindurch mindestens bis zu der zweiten Halbleiterschicht 3 aus p-leitend dotiertem GaAs eine Implantation von p-Dotierung a zur Ausbildung von Basis-Implantaten 11.

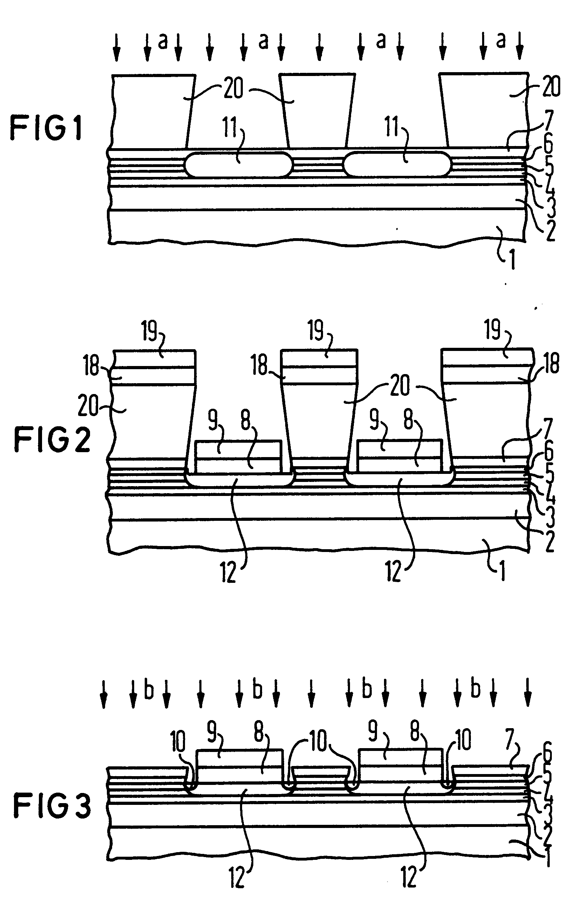

Figur 1 zeigt den Querschnitt des Emitter-Basis-Komplexes nach diesem dritten Verfahrensschritt.

In einem vierten Schritt werden in den von der ersten Maskenschicht 20 nicht abgedeckten Bereichen die Passivierungsschicht 7 und die oberste Halbleiterschicht 6 weggeätzt. Dieser vierte Schritt kann auch vor dem dritten Schritt erfolgen, wenn durch geeignete Maßnahmen das geforderte Dotierungsprofil erzeugt wird.

In einem fünften Schritt wird eine, in der Regel mehrlagige erste Metallschicht 8, 18 aufgebracht. Ein erster Anteil dieser Metallschicht 8 bildet die Basis-Metallisierung 8. Ein zweiter Anteil 18 dieser ersten Metallschicht befindet sich auf der ersten Maskenschicht 20. Für diese erste Metallschicht 8, 18 wird eine auf p-leitend dotiertem Halbleitermaterial hochtemperaturfeste Metallisierung verwendet. Diese kann z.B. darin bestehen, daß zunächst Titan, danach Platin und als drittes Metall entweder ebenfalls Titan oder Gold verwendet wird. Eine aus fünf Lagen bestehende Metallisierung liefert die Folge Titan, Platin, Gold, Titan und Platin. Wesentlich ist dabei, daß diese Metallisierung einen nachfolgenden Temperatur-Zeit-Zyklus zum Ausheilen der Basis-Implantate 11 dergestalt übersteht, daß die Kontaktwiderstände für die Funktionsweise des Transistors ausreichend niedrig sind. In einem sechsten Schritt wird dann eine erste Dielektrikumschicht 9, 19, z.B. aus $SiO_2$, mit einer Dicke von ca. 200 nm abgeschieden. Der erste Anteil 9 dieser ersten Dielektrikumschicht befindet sich auf der Basis-Metallisierung 8, ein zweiter Anteil 19 dieser ersten Dielektrikumschicht befindet sich auf dem zweiten Anteil 18 der ersten Metallschicht.

Figur 2 zeigt den Emitter-Basis-Komplex im Querschnitt nach diesem sechsten Verfahrensschritt.

In einem siebten Schritt wird die erste Maskenschicht 20 zusammen mit dem zweiten Anteil 18 der ersten Metallschicht und dem darauf befindlichen zweiten Anteil 19 der ersten Dielektrikumschicht entfernt (lift off).

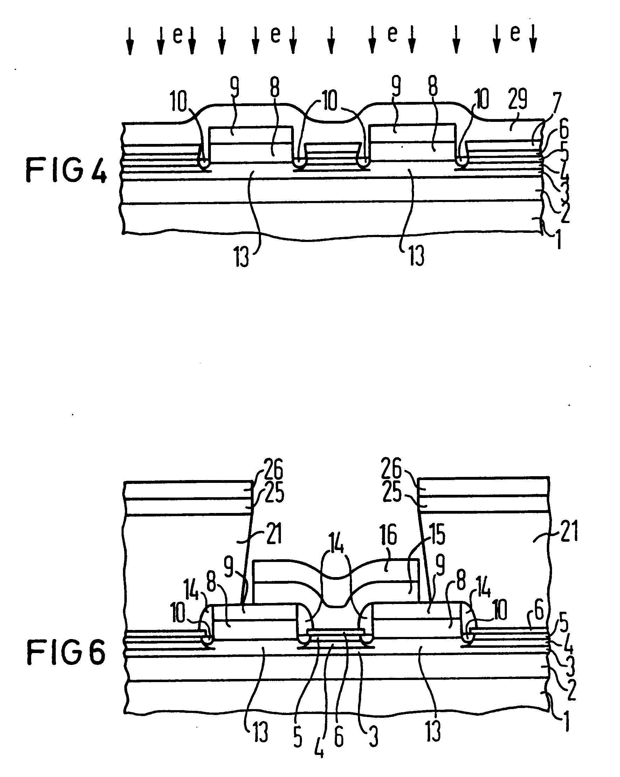

Figur 3 zeigt den Emitter-Basis-Komplex im Querschnitt nach diesem siebten Verfahrensschritt.

In einem achten Schritt erfolgt das Ausheilen der implantierten Dotierung durch einen Temperatur-Zeit-Zyklus, mit dem gleichzeitig die Basis-Metallisierung 8 einlegiert wird. Bei den genannten Metallisierungen kann ein Kurzzeit-Ausheilverfahren angewendet werden, bei dem das Ausheilen bei einer Temperatur zwischen 850° und 900° C und einer Zeitdauer von zwei bis drei Sekunden geschieht. Eine weitere Ausgestaltung dieses Herstellungsverfahrens sieht vor, daß Isolationsimplantate 10 zur Isolierung der Basisbereiche 12 von den darum herum befindlichen n-leitend dotierten Schichten vor oder nach dem Ausheilschritt (Schritt 8) eingebracht werden.

In einem neunten Schritt wird ganzflächig oder zumindest den Bereich der auszubildenden Basis abdeckend isotrop eine zweite Dielektrikumschicht 29, z.B. aus Siliziumnitrid, die eine für die nachfolgende Ausbildung von Spacern hinreichend dicke Schicht bildet, abgeschieden.

Figur 4 zeigt den Emitter-Basis-Komplex im Querschnitt nach diesem neunten Verfahrensschritt.

In einem zehnten Schritt werden mittels anisotropen Ätzens diese zweite Dielektrikumschicht 29 und die Passivierungsschicht 7 so weit weggeätzt, daß Spacer 14 stehenbleiben, die nur die Seiten der auf den Basis-Bereichen 12 aufgebrachten Basis-Metallisierungen 8 und ersten Anteile 9 der ersten Dielektrikumschicht bedecken, wobei insbesondere die Seiten der Basis-Metallisierungen 8 vollständig isolierend abgedeckt werden.

Figur 5 zeigt den Emitter-Basis-Komplex im Querschnitt nach diesem zehnten Verfahrensschritt.

In einem elften Schritt wird eine zweite Maskenschicht 21, die wieder eine Fotolackmaske sein kann, mit einer Öffnung zur Definition des Emitters aufgebracht und danach in einem zwölften Schritt eine zweite Metallschicht mit einem ersten Anteil als Emitter-Metallisierung 15 und einem zweiten Anteil 25, der auf der zweiten Maskenschicht 21 abgeschieden wird. In einem dreizehnten Schritt wird nun eine dritte Dielektrikumschicht mit einem ersten Anteil 16 auf der Emitter-Metallisierung 15 und einem zweiten Anteil 26 auf dem zweiten, auf der zweiten Maskenschicht 21 befindlichen Anteil 25 der zweiten Metallschicht aufgebracht.

Figur 6 zeigt den Emitter-Basis-Komplex im Querschnitt nach diesem dreizehnten Verfahrensschritt.

In einem vierzehnten Schritt wird die zweite Maskenschicht 21 zusammen mit dem darauf befindlichen zweiten Anteil 25 der zweiten Metallschicht und dem zweiten Anteil 26 der dritten Dielektrikumschicht entfernt (lift off).

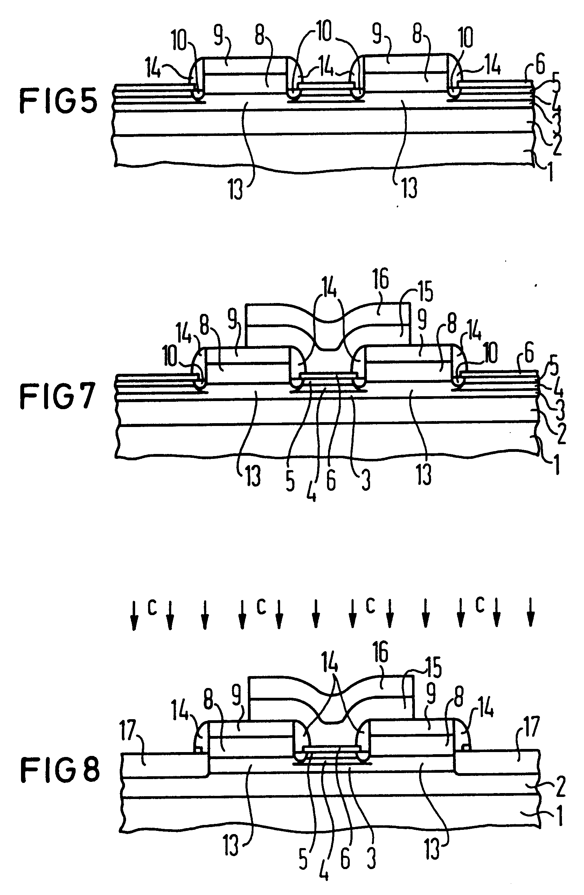

Figur 7 zeigt den Emitter-Basis-Komplex im Querschnitt nach diesem vierzehnten Verfahrensschritt.

In einem fünfzehnten Schritt wird die Emitter-Metallisierung 15 einlegiert. In einem sechzehnten Schritt werden die freiliegenden, d.h. außerhalb der mit Metallisierung versehenen Bereiche befindlichen Anteile der obersten Halbleiterschicht 6 weggeätzt. In einem siebzehnten Schritt werden die außerhalb der von Basis und Emitter eingenommenen Bereiche der Oberfläche befindlichen Anteile der Halbleiterschichtstruktur 2, 3, 4, 5 auf der dem Substrat 1 abgewandten Seite bis zu der p-leitend dotierten Halbleiterschicht 3 einschließlich durch Isolationsimplantation c isolierend gemacht.

Figur 8 zeigt den Querschnitt des Emitter-Basis-Komplexes nach diesem siebzehnten Verfahrensschritt.

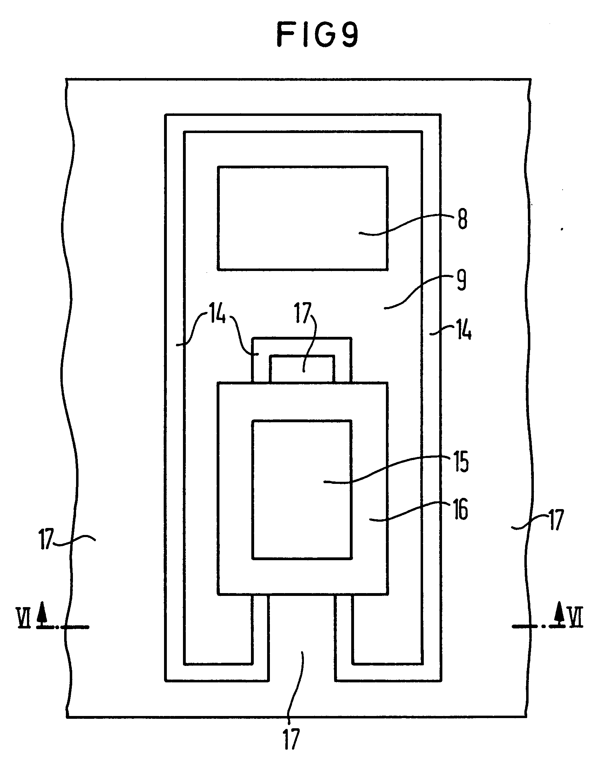

Nach der Herstellung des Kollektors werden die Kontaktlöcher für Basis, Emitter und Kollektor gleichzeitig durch einen Ätzprozeß hergestellt. Den Emitter-Basis-Komplex des fertigen Transistors ohne Elektroden in der Aufsicht zeigt Figur 9.

Eine alternative Ausgestaltung des erfindungsgemäßen Verfahrens sieht nach dem zehnten Schritt (siehe Fig. 5) folgenden Prozeßverlauf vor: In einem elften Schritt wird eine zweite Metallschicht 35 auf die mit der Basis-Metallisierung 8 versehene Oberfläche ganzflächig, d.h. zumindest den Bereich des auszubildenden Emitter-Kontaktes vollständig überdeckend, abgeschieden. In einem zwölften Schritt wird eine dritte Dielektrikumschicht 36 auf dieser zweiten Metallschicht 35 abgeschieden. In einem dreizehnten Schritt wird zur Definiton des Emitters, d.h. zur Festlegung dessen geometrischer Struktur, eine zweite Maskenschicht 22 aufgebracht.

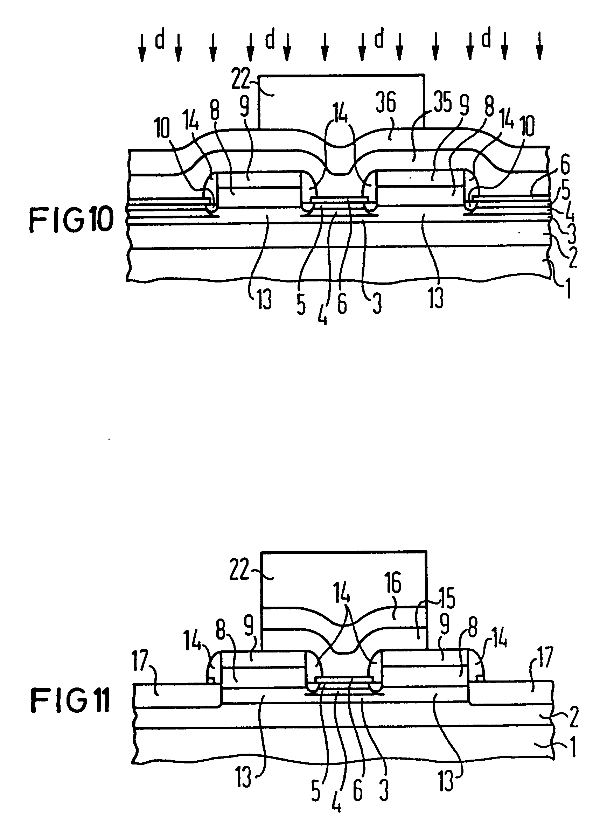

Figur 10 zeigt den Emitter-Basis-Komplex im Querschnitt nach diesem dreizehnten Schritt.

Die nicht von der zweiten Maskenschicht 22 bedeckten Teile der zweiten Metallschicht 35 und der dritten Dielektrikumschicht 36 werden in einem vierzehnten Schritt mittels anisotropen Ätzens d weggeätzt, so daß von der zweiten Metallschicht 35 nur ein Anteil, der die Emitter-Metallisierung 15 darstellt, übrig bleibt.

Figur 11 zeigt den Emitter-Basis-Komplex im Querschnitt nach diesem vierzehnten Verfahrensschritt.

In einem fünfzehnten Schritt wird die zweite Maskenschicht 22 entfernt und in einem sechzehnten Schritt die Emitter-Metallisierung 15 einlegiert. Es ist damit der in Figur 7 dargestellte Prozeßschritt erreicht.

In einem siebzehnten Schritt werden die freiliegenden Anteile der obersten Halbleiterschicht 6 weggeätzt und in einem achtzehnten Schritt die außerhalb der von Basis und Emitter eingenommenen Bereiche der Oberfläche befindlichen Anteile der Halbleiterschichtstruktur 2, 3, 4, 5, auf der dem Substrat 1 abgewandten Seite bis zu der p-leitend dotierten Halbleiterschicht 3 einschließlich durch Isolationsimplantation c isolierend gemacht. Der Emitter-Basis-Komplex besitzt jetzt den in Figur 8 im Querschnitt gezeigten Aufbau. Anschließend erfolgt die Herstellung des Kollektors, das Ätzen der Kontaktlöcher (Figur 9) und das Anbringen von Elektroden.

**Patentansprüche**

1. Verfahren zur Herstellung eines Heterobipolartransistors,
bei dem in einem ersten Schritt auf ein Substrat (1) aus Halbleitermaterial eine dotierte Kollektorschicht (2), eine dazu entgegengesetzt dotierte Basisschicht (3) und eine dotierte Emitterschicht (4, 5, 6) aufgebracht werden,
bei dem in einem zweiten Schritt eine erste Maskenschicht (20) mit einer Öffnung zur Definition der Basis aufgebracht wird,
bei dem in einem dritten Schritt im Bereich dieser Öffnung eine Implantation von Dotierung (a) für ein Leitungstyp der Basisschicht (3) mindestens bis zu der Basisschicht (3) hin erfolgt und eine hoch dotierte, dem Substrat abgewandte oberste Halbleiterschicht (6) der Emitterschicht (4, 5, 6) weggeätzt wird,
bei dem in einem vierten Schritt eine erste Metallschicht (8, 18) aus einem hochtemperaturfesten Metall mit einem Anteil in der Öffnung der ersten Maskenschicht (20) als Basis-Metallisierung (8) aufgebracht wird,
bei dem in einem fünften Schritt eine erste Dielektrikumschicht (9, 19) auf der ersten Metallschicht (8, 18) abgeschieden wird,
bei dem in einem sechsten Schritt in Abhebetechnik die erste Maskenschicht (20) mit darauf befindlichen Anteilen (18, 19) der ersten Metallschicht und der ersten Dielektrikumschicht entfernt wird,
bei dem in einem siebten Schritt ein Temperzyklus erfolgt, mit dem gleichzeitig die implantierte Dotierung ausgeheilt und die Basis-Metallisierung (8) einlegiert wird,
bei dem in einem achten Schritt Spacer (14) an den Seiten der Basis-Metallisierung (8) ausgebildet werden, indem eine zweite Dielektrikumschicht (29) isotrop abgeschieden und anisotrop rückgeätzt wird,
bei dem in einem neunten Schritt unter Anwendung von Maskentechnik die Oberfläche der Emitterschicht (4, 5, 6) im Bereich zwischen diesen Spacern (14) mit einer Emitter-Metallisierung (15) versehen wird und
bei dem in einem zehnten Schritt diese Emitter-Metallisierung (15) einlegiert wird.

2. Verfahren nach Anspruch 1,
bei dem in dem neunten Schritt eine zweite Maskenschicht (21) mit einer Öffnung für die Emitter-Metallisierung aufgebracht wird,
dann eine zweite Metallschicht (15, 25) mit einem Anteil in dieser Öffnung der zweiten Maskenschicht (21) als Emitter-Metallisierung (15) und darauf eine dritte Dielektrikumschicht (16, 26) abgeschieden werden und
dann in Abhebetechnik die zweite Maskenschicht (21) mit darauf befindlichen Anteilen (25, 26) der zweiten Metallschicht und der dritten Dielektrikumschicht entfernt wird.

3. Verfahren nach Anspruch 1,
bei dem in dem neunten Schritt eine zweite Metallschicht (35) und eine dritte Dielektrikumschicht (36) ganzflächig aufgebracht werden,
dann eine zweite Maskenschicht (22) mit den für die Emitter-Metallisierung vorgesehenen lateralen Abmessungen aufgebracht wird,
dann die nicht von dieser zweiten Maskenschicht (22) bedeckten Teile der zweiten Metallschicht (35) und der dritten Dielektrikumschicht (36) anisotrop weggeätzt werden, so daß von der zweiten Metallschicht (35) nur die Emitter-Metallisierung (15) übrigbleibt, und
dann die zweite Maskenschicht (22) entfernt wird.

4. Verfahren nach einem der Ansprüche 1 bis 3,
bei dem unmittelbar vor oder nach dem Temperzyklus zum Ausheilen der implantierten Dotierung eine Isolationsimplantierung vorgenommen wird, um die mit der Basis-Metallisierung (8) versehenen Bereiche von dem Halbleitermaterial, das entgegengesetzt zur Basisschicht (3) dotiert ist, zu isolieren.

5. Verfahren nach einem der Ansprünche 1 bis 4,
bei dem im ersten Schritt auf die Emitterschicht (4, 5, 6) ganzflächig eine Passivierungsschicht (7) aufgebracht wird,
bei dem diese Passivierungsschicht (7) im dritten Schritt im Bereich der Öffnung der ersten Maskenschicht (20) entfernt wird, und
bei dem diese Passivierungsschicht (7) bei der Herstellung der Spacer (14) im achten Schritt zusammen mit der zweiten Dielektrikumschicht (29) rückgeätzt wird.

6. Verfahren nach einem der Ansprüche 1 bis 5,
bei dem in einem elften Schritt freiliegende Anteile der hoch dotierten obersten Halbleiterschicht (6) der Emitterschicht (4, 5, 6) weggeätzt werden und
bei dem in einem zwölften Schritt die Basisschicht (3) und die Emitterschicht (4, 5) außerhalb der von der Basis und dem Emitter eingenommenen Bereiche durch Isolationsimplantation (c) isolierend gemacht werden.

7. Verfahren nach einem der Ansprüche 1 bis 6,
bei dem die erste Dielektrikumschicht (9, 19) und die dritte Dielektrikumschicht (16, 26, 36) $SiO_2$ sind und die zweite Dielektrikumschicht (29) $Si_3N_4$ ist.

8. Verfahren nach einem der Ansprüche 1 bis 7,
bei dem das Substrat (1) semiisolierendes GaAs ist,
bei dem die Kollektorschicht (2) dotiertes GaAs eines ersten Leitungstyps ist,
bei dem die Basisschicht (3) dotiertes GaAs des entgegengesetzten Leitungstyps ist und
bei dem die Emitterschicht (4, 5, 6) eine auf die Basisschicht (3) aufgebrachte Schicht (4) aus dotiertem AlGaAs des ersten Leitungstyps, eine darauf aufgebrachte Schicht (5) aus dotiertem GaAs des ersten Leitungstyps und eine darauf aufgebrachte oberste Schicht (6) aus hoch dotiertem GaAs des ersten Leitungstyps umfaßt.

## Claims

1. Method for producing a heterojunction bipolar transistor, in which a doped collector layer (2), a base layer (3) which has opposite doping thereto, and a doped emitter layer (4, 5, 6) are applied in a first step onto a substrate (1) comprising semiconductor material, in which a first mask layer (20) having an opening for definition of the base is applied in a second step, in which implantation of doping (a) for a conductance type of the base layer (3) at least as far as the base layer (3) takes place in the region of this opening in a third step, and a highly doped top semiconductor layer (6), averted from the substrate, of the emitter layer (4, 5, 6) is etched away, in which a first metal layer (8, 18), comprising a high-temperature-resistant metal, is applied with a portion in the opening of the first mask layer (20) as base metallisation (8) in a fourth step, in which a first dielectric layer (9, 19) is deposited on the first metal layer (8, 18) in a fifth step, in which the first mask layer (20) with the portions (18, 19) located thereon of the first metal layer and of the first dielectric layer is removed in a sixth step using a lift-off technique, in which a heat cycle takes place in a seventh step, by means of which, simultaneously, the implanted doping is completely annealed and the base metallisation (8) is alloyed-in, in which spacers (14) are constructed on the sides of the base metallisation (8) in an eighth step, in that a second dielectric layer (29) is isotropically deposited and is anisotropically etched back, in which, using a mask technology, the surface of the emitter layer (4, 5, 6) is provided in a ninth step in the region between these spacers (14) with emitter metallisation (15), and in which this emitter metallisation (15) is alloyed-in in a tenth step.

2. Method according to Claim 1, in which a second mask layer (21) having an opening for the emitter metallisation is applied in the ninth step, a second metal layer (15, 25) having a portion in this opening of the second mask layer (21) is then deposited as emitter metallisation (15) and a third dielectric layer (16, 26) is deposited thereon, and the second mask layer (21) with the components (25, 26) located thereon of the second metal layer and of the third dielectric layer are then removed using a lift-off technique.

3. Method according to Claim 1, in which a second metal layer (35) and a third dielectric layer (36) are applied over the complete area in the ninth step, a second mask layer (22) having the lateral dimensions provided for the emitter metallisation is then applied, the parts of the second metal layer (35) and of the third dielectric layer (36) which are not covered by this second mask layer (22) are then anisotropically etched away so that only the emitter metallisation (15) remains of the second metal layer (35), and the second mask layer (22) is then removed.

4. Method according to one of Claims 1 to 3, in which, directly before or after the heat cycle for completely annealing the implanted doping, an insulation implantation is carried out in order to insulate the regions which are provided with the base metallisation (8) of the semiconductor material which is doped oppositely to the base layer (3).

5. Method according to one of Claims 1 to 4, in which a passivation layer (7) is applied over the complete area on the emitter layer (4, 5, 6) in the first step, in which this passivation layer (7) is removed in the region of the opening of the first mask layer (20) in the third step, and in which this passivation layer (7) is etched back together with the second dielectric layer (29) during the production of the spacers (14) in the eighth step.

6. Method according to one of Claims 1 to 5, in which exposed components of the highly doped top semiconductor layer (6) of the emitter layer (4, 5, 6) are etched away in an eleventh step and in which the base layer (3) and the emitter layer (4, 5) outside the regions which are occupied by the base and the emitter are made insulating by insulation implantation (c) in a twelfth step.

7. Method according to one of Claims 1 to 6, in which the first dielectric layer (9, 19) and the third dielectric layer (16, 26, 36) are $SiO_2$ and the second dielectric layer (29) is $Si_3N_4$.

8. Method according to one of Claims 1 to 7, in which the substrate (1) is semi-insulating GaAs, in which the collector layer is doped GaAs of a first conductance type, in which the base layer (3) is doped GaAs of the opposite conductance type and in which the emitter layer (4, 5, 6) comprises a layer (4) which is applied onto the base layer (3) and is of doped AlGaAs of the first conductance type, a layer (5) of doped GaAs of the first conductance type applied thereon, and a top layer (6) of highly doped GaAs of the first conductance type applied thereon.

**Revendications**

1. Procédé pour fabriquer un transistor bipolaire à hétérojonction, selon lequel lors d'une première étape, on dépose sur un substrat (1) formé d'un matériau semiconducteur, une couche dopée de collecteur (2), une couche de base (3) dopée avec un dopage opposé, et une couche dopée d'émetteur (4,5,6),
lors d'une seconde étape, on dépose une première couche formant masque (20) possédant une ouverture servant à définir la base,
lors d'une troisième étape, on exécute, dans la zone de cette ouverture, une implantation d'une substance dopante (a) pour un type de conductivité de la couche de base (3) au moins jusqu'à cette couche de base (3), et on élimine par corrosion une couche semiconductrice supérieure fortement dopée (6), tournée à l'opposé du substrat, de la couche d'émetteur (4,5,6),
lors d'une quatrième étape, on dépose une première couche métallique (8,18) formée d'un matériau résistant aux températures élevées, dont une partie sert de métallisation de base (8) dans l'ouverture de la première couche formant masque (20),
lors d'une cinquième étape, on dépose une première couche diélectrique (9,19) sur la première couche métallique (8,18), lors d'une sixième étape, on élimine, au moyen de la technique de décollement, la première couche formant masque (20) sur laquelle sont situées des parties (18,19) de la première couche métallique et de la première couche diélectrique,
lors d'une septième étape, on exécute un cycle de recuit, lors duquel simultanément la substance dopante implantée est soumise à un recuit et la métallisation de base (8) est fixée par alliage,

lors d'une huitième étape, on forme des entretoises (14) sur les côtés de la métallisation de base (8) en déposant d'une manière isotrope une seconde couche diélectrique (29) et en appliquant une rétrocorrosion anisotrope à cette couche,
lors d'une neuvième étape, en utilisant la technique de masquage, on dépose une métallisation d'émetteur (15) sur la surface de la couche d'émetteur (4,5,6), dans la zone située entre ces entretoises (14), et
lors d'une dixième étape, on fixe par alliage cette métallisation d'émetteur (15).

2. Procédé suivant la revendication 1, selon lequel lors de la neuvième étape, on dépose une seconde couche formant masque (21) comportant une ouverture pour la métallisation d'émetteur,
ensuite on dépose une seconde couche métallique (15,25) dont une partie située dans cette ouverture de la seconde couche de masque (21) sert de métallisation de l'émetteur (15) et on dépose, par-dessus, une troisième couche diélectrique (16,26), et
ensuite on élimine, selon une technique de décollement, la seconde couche de masque (21) sur laquelle sont situées des parties (25,26) de la seconde couche métallique et de la troisième couche diélectrique.

3. Procédé selon la revendication 1, selon lequel lors de la neuvième étape, on dépose, sur l'ensemble de la surface, une seconde couche métallique (35) et une troisième couche diélectrique (36),
on dépose ensuite une seconde couche formant masque (22) ayant des dimensions latérales prévues pour la métallisation d'émetteur,
on élimine ensuite par corrosion anisotrope les parties, non recouvertes par cette seconde couche formant masque (22), de la seconde couche métallique (35) et de la troisième couche diélectrique (36) de sorte que seule subsiste, de la seconde couche métallique (35), la métallisation d'émetteur (15), et on élimine ensuite la seconde couche formant masque (22).

4. Procédé suivant l'une des revendications 1 à 3, selon lequel
directement avant ou après le cycle de recuit de la substance dopante implantée, on exécute une implantation d'isolation pour isoler les parties, pourvues de la métallisation de base (8), par rapport au matériau semiconducteur, qui est dopé avec un dopage opposé à la couche de base (3).

**5.** Procédé suivant l'une des revendications 1 à 4, selon lequel

lors de la première étape, on dépose une couche de passivation (7) sur toute la surface de la couche d'émetteur (4,5,6),

lors de la troisième étape, on élimine cette couche de passivation (7) dans la zone de l'ouverture de la première couche formant masque (20), et

lors de la fabrication des entretoises (14), lors de la huitième étape, on applique une rétrocorrosion à cette couche de passivation (7) ainsi qu'à la seconde couche diélectrique (29).

**6.** Procédé selon l'une des revendications 1 à 5, selon lequel

lors d'une onzième étape, on élimine par corrosion les parties mises à nu de la couche semiconductrice supérieure fortement dopée (6) de la couche d'émetteur (4,5,6), et

lors d'une douzième étape, on rend isolantes la couche de base (3) et la couche d'émetteur (4,5) à l'extérieur des zones occupées par la base et par l'émetteur, au moyen d'une implantation d'isolation (c).

**7.** Procédé suivant l'une des revendications 1 à 6, selon lequel

la première couche diélectrique (9,19) et la troisième couche diélectrique (16,26,36) sont formées de $SiO_2$ et la seconde couche diélectrique (29) est formée de $Si_3N_4$.

**8.** Procédé suivant l'une des revendications 1 à 7, selon lequel

le substrat (1) est formé de GaAs semi-isolant,

la couche de collecteur (2) est du GaAs dopé possédant un premier type de conductivité,

la couche de base (3) est du GaAs dopé possédant le type de conductivité opposé, et

la couche d'émetteur (4,5,6) comprend une couche (4) déposée sur la couche de base (3) et formée de AlGaAs dopé possédant le premier type de conductivité, une couche (5) déposée sur la couche d'émetteur et formé par du GaAs dopé possédant le premier type de conductivité, et une couche supérieure (6) déposée sur la couche précédente et formée par du GaAs fortement dopé et possédant le premier type de conductivité.

FIG1

FIG2

FIG3

FIG 4

FIG 6

**FIG5**

**FIG7**

**FIG8**

# FIG 9

FIG 10

FIG 11